# EUROPEAN PATENT APPLICATION

(11) **EP 4 818 847 A1**
(43) Date of publication of application: **07.10.2026**
(21) Application number: 24896450.4
(22) Date of filing: 25.11.2024
(51) Int. Cl.: G06F 1/16, F16C 11/04, H04M 1/02

(54) **HINGE MECHANISM AND ELECTRONIC DEVICE**

(30) Priority: 30.11.2023 CN 202311646180
(71) Applicant: Vivo Mobile Communication Co., Ltd., Dongguan, Guangdong 523863 (CN)
(72) Inventor: TAN, Yufeng, Dongguan, Guangdong 523863 (CN); FAN, Xiaofei, Dongguan, Guangdong 523863 (CN); GAO, Guofeng, Dongguan, Guangdong 523863 (CN); LIU, Wenjun, Dongguan, Guangdong 523863 (CN); YANG, Dajun, Dongguan, Guangdong 523863 (CN); ZHANG, Xiaoqing, Dongguan, Guangdong 523863 (CN)
(74) Representative: Lavoix
(86) International application number: PCT/CN2024/134074
(87) International publication number: WO 2025/113359

(57) **Abstract**

This application relates to the field of hinge technologies and discloses a hinge mechanism and an electronic device. The disclosed hinge mechanism includes a base, a first swing arm, a second swing arm, and a synchronizing link. Both the first swing arm and the second swing arm are rotationally connected to the base. The synchronizing link includes a first end and a second end that are opposite to each other, and the first end and the second end are respectively rotationally connected to the first swing arm and the second swing arm that are located on a same side of the base, so that the first swing arm and the second swing arm rotate synchronously relative to the base.

## Description

### CROSS-REFERENCE TO RELATED APPLICATIONS

This application claims priority to Chinese Patent Application No. 202311646180.6, entitled "HINGE MECHANISM AND ELECTRONIC DEVICE" filed with the China National Intellectual Property Administration on November 30, 2023, which is incorporated herein by reference in its entirety.

### TECHNICAL FIELD

This application relates to the field of hinge technologies, and in particular, to a hinge mechanism and an electronic device.

### BACKGROUND

With rapid development of electronic devices, to pursue large-screen display experience and portable convenience, foldable devices such as a foldable-screen mobile phone, a tablet, and a computer become increasingly preferred for most users.

A core component of an electronic device for implementing folding is a hinge mechanism. A hinge region of the hinge mechanism needs to be mainly formed by a combination of a base and different types of swing arms, and is connected to a frame of the electronic device through a frame connector, to form a contact angle in a process of folding a screen, thereby reducing bending stress of a foldable screen.

During rotation of the swing arms relative to the base, rotation centers of different types of swing arms are inconsistent, causing a problem of unsynchronized rotation of the swing arms, thereby causing a problem that the swing arms are prone to be stuck in rotational or slidable cooperation with the base or the frame connector.

### SUMMARY

This application discloses a hinge mechanism and an electronic device, to resolve a problem in the conventional technology that a swing arm is prone to be stuck in rotational or slidable cooperation with a base or a frame connector caused by unsynchronized rotation of different types of swing arms.

According to a first aspect, an embodiment of this application discloses a hinge mechanism. The disclosed hinge mechanism includes a base, a first swing arm, a second swing arm, and a synchronizing link, where both the first swing arm and the second swing arm are rotationally connected to the base; and
the synchronizing link includes a first end and a second end that are opposite to each other, and the first end and the second end are respectively rotationally connected to the first swing arm and the second swing arm that are located on a same side of the base, so that the first swing arm and the second swing arm rotate synchronously relative to the base, where an extension direction of the synchronizing link intersects or is non-coplanar to a rotation axis of the first swing arm or a rotation axis of the second swing arm.

According to a second aspect, an embodiment of this application discloses an electronic device. The disclosed electronic device includes a first device body, a second device body, and the foregoing hinge mechanism, where the first device body is connected to the second device body through the hinge mechanism; and
in a relative rotation process of the first device body and the second device body, the electronic device switches between an unfolded state and a folded state.

The technical solutions used in this application can achieve the following technical effects.

The hinge mechanism disclosed in the embodiments of this application makes improvement to the conventional technology. The hinge mechanism includes a base, a first swing arm, a second swing arm, and a synchronizing link. Both the first swing arm and the second swing arm are rotationally connected to the base. The synchronizing link includes a first end and a second end that are opposite to each other, and the first end and the second end are respectively rotationally connected to the first swing arm and the second swing arm that are located on a same side of the base, so that the first swing arm and the second swing arm rotate synchronously relative to the base, thereby avoiding a problem that the first swing arm and the second swing arm are prone to be stuck in rotational or slidable cooperation with the base or a frame connector, and improving stability of the hinge mechanism.

### BRIEF DESCRIPTION OF THE DRAWINGS

FIG. 1 is a first schematic structural diagram of a hinge mechanism in an unfolded state according to an embodiment of this application;
FIG. 2 is a first schematic structural diagram of a hinge mechanism in a folded state according to an embodiment of this application;
FIG. 3 is a second schematic structural diagram of a hinge mechanism in an unfolded state according to an embodiment of this application;
FIG. 4 is a second schematic structural diagram of a hinge mechanism in a folded state according to an embodiment of this application;
FIG. 5 is a first sectional view of a hinge mechanism according to an embodiment of this application;
FIG. 6 is a second sectional view of a hinge mechanism according to an embodiment of this application;
FIG. 7 is a third schematic structural diagram of a hinge mechanism in a folded state according to an embodiment of this application;
FIG. 8 is a third schematic structural diagram of a hinge mechanism in an unfolded state according to an embodiment of this application; and
FIG. 9 is a schematic structural diagram of an electronic device according to an embodiment of this application.

### Description of reference numerals:

1-electronic device; 10-hinge mechanism; 20-first device body; and 30-second device body;
100-base, 120-rotary shaft, 130-elastic member, 140-first movement member, 150-second movement member, and 160-engagement portion;
200-first swing arm, 201-first sub-swing arm, 202-second sub-swing arm, 203-first cam portion, 204-second cam portion, 205-third cam portion, 210-first mounting portion, 220-first pin shaft, and 230-first avoidance groove;
300-second swing arm, 310-bearing shell, 320-second mounting portion, 330-second pin shaft, and 340-second avoidance groove;
400-synchronizing link;
500-frame connector; and
600-synchronization mechanism.

### DETAILED DESCRIPTION

To clearly states the objectives, technical solutions, and advantages of this application, the technical solutions of this application will be clearly and completely described below with reference to specific embodiments of this application and the accompanying drawings. Clearly, the described embodiments are merely some rather than all of embodiments of this application. All other embodiments obtained by a person of ordinary skill in the art based on the embodiments of this application without creative efforts shall fall within the protection scope of this application.

The terms such as "first" and "second" in this specification and the claims of this application are used to distinguish between similar objects, but are not used to describe a specific sequence or order. It should be understood that data used in such a way is exchangeable in a proper case, so that the embodiments of this application can be implemented in a sequence different from that illustrated or described herein. The objects distinguished by using "first", "second", and the like are usually of one type, and a quantity of the objects is not limited. For example, one or more first objects may be provided. In addition, "and/or" in this specification and the claims indicates at least one of connected objects, and the character "/" generally indicates an "or" relationship between associated objects.

The following describes the technical solutions disclosed in the embodiments of this application in detail with reference to the accompanying drawings.

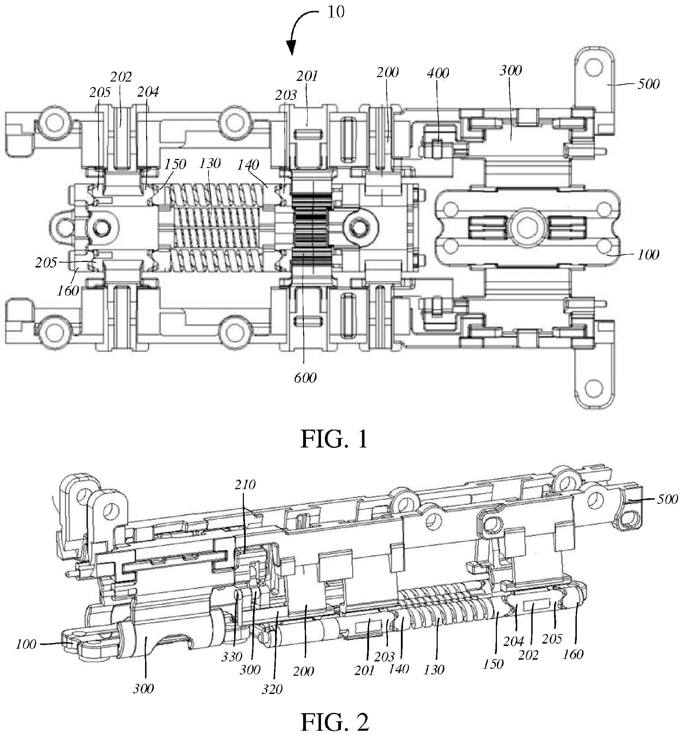

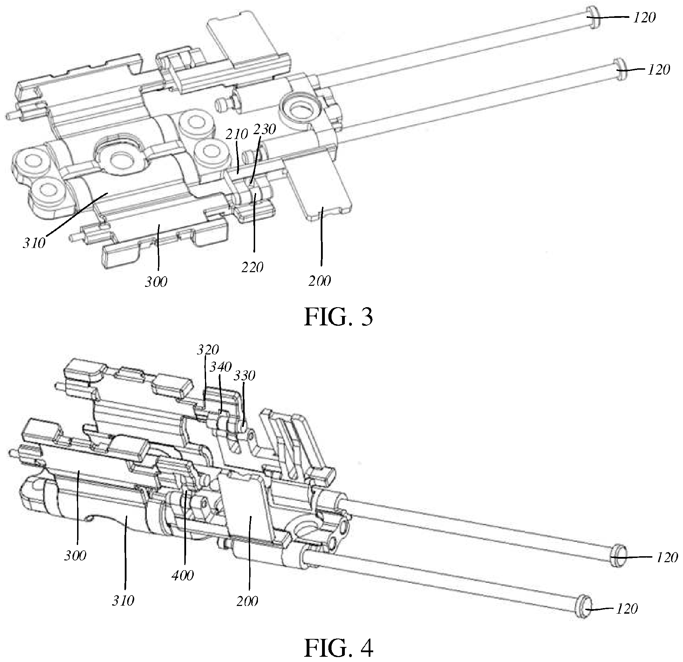

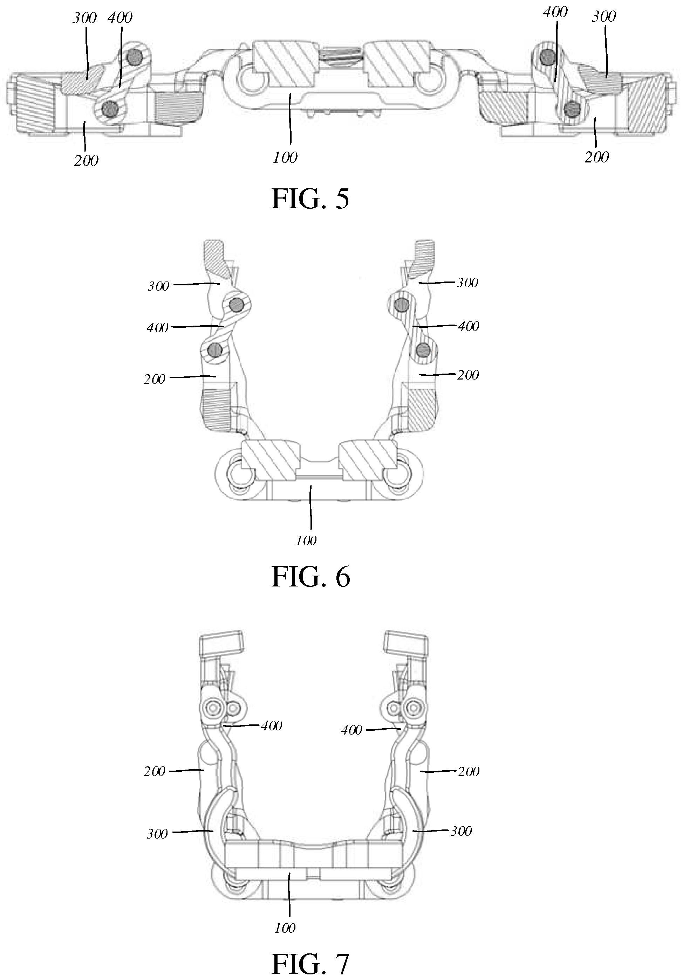

Refer to FIG. 1 to FIG. 8. Embodiments of this application discloses a hinge mechanism 10. The disclosed hinge mechanism 10 may include a base 100, a first swing arm 200, a second swing arm 300, and a synchronizing link 400.

The base 100 is used as a mounting basis for the first swing arm 200 and the second swing arm 300, both the first swing arm 200 and the second swing arm 300 are rotationally connected to the base 100, and the first swing arm 200 and the second swing arm 300 are rotationally connected to two sides of the base 100 that are opposite to each other. Specific rotational connection may be implemented in a manner like cooperation of a rotary shaft 120, a bearing shell 310, and a sliding groove. The first swing arm 200 may be a synchronization swing arm configured to control structural members on the two sides of the base 100 to synchronously rotate, and the second swing arm 300 may be a virtual swing arm configured to support rotation of the structural members on the two sides of the base 100.

It should be noted that the structural members on the two sides of the base 100 may include a frame connector 500 and a housing of an electronic device. The housing includes two parts located on the two sides of the base 100. The second swing arm 300 is connected to a housing on a same side through the frame connector 500 located on the same side, and drives the housing on the same side of the base 100 to switch between a folded state and an unfolded state. The first swing arm 200 is slidably connected to the housing, and is configured to control the housing on the two sides of the base 100 to synchronously rotate.

Because rotation axes of the first swing arm 200 and the second swing arm 300 are inconsistent, during rotation of the first swing arm 200 and the second swing arm 300 relative to the base 100, a problem of unsynchronized rotation may exist, causing a problem that the first swing arm 200 and the second swing arm 300 are prone to be stuck in rotational or slidable cooperation with the base 100 or the frame connector 500.

In view of the foregoing problem, in this embodiment of this application, as shown in FIG. 1 to FIG. 4, the synchronizing link 400 may be disposed between the first swing arm 200 and the second swing arm 300. Specifically, the synchronizing link 400 includes a first end and a second end that are opposite to each other, and the first end and the second end of the synchronizing link 400 are respectively rotationally connected to the first swing arm 200 and the second swing arm 300 that are located on a same side of the base 100, so that the first swing arm 200 and the second swing arm 300 rotate synchronously relative to the base 100. It may be understood that, in a process in which the first swing arm 200 and the second swing arm 300 that are located on the same side of the base 100 rotate or slide with the housing on the same side, the synchronizing link 400 respectively applies forces to the first swing arm 200 and the second swing arm 300 through the first end and the second end, to achieve relative synchronous movement of the first swing arm 200 and the second swing arm 300, thereby alleviating the problem that the first swing arm 200 and the second swing arm 300 are prone to be stuck in rotational or slidable cooperation with the base 100 or the frame connector 500.

Both the rotation axis of the first swing arm 200 and the rotation axis of the second swing arm 300 are located on the base 100. The first swing arm 200 and the second swing arm 300 respectively rotate relative to the base 100 around the respective rotation axis. An extension direction of the synchronizing link 400, that is, a length direction of the synchronizing link 400, intersects or is non-coplanar to the rotation axis of the first swing arm 200 or the rotation axis of the second swing arm 300. The synchronizing link 400 may respectively pull the first swing arm 200 and the second swing arm 300 along two ends in the extension direction of the synchronizing link 400, to achieve relative synchronous movement of the first swing arm 200 and the second swing arm 300.

It can be known from the foregoing descriptions that the hinge mechanism 10 disclosed in this embodiment of this application makes improvement to the conventional technology. The synchronizing link 400 is disposed between the first swing arm 200 and the second swing arm 300, so that the first swing arm 200 and the second swing arm 300 rotate synchronously relative to the base 100 under an action of the synchronizing link 400, thereby avoiding the problem that the first swing arm 200 and the second swing arm 300 are prone to be stuck in rotational or slidable cooperation with the base 100 or the frame connector 500 due to poor synchronization, and improving stability of the hinge mechanism 10.

In an optional implementation of this application, as shown in FIG. 1 to FIG. 4, a protruding first mounting portion 210 is disposed on a side, facing the second swing arm 300, of the first swing arm 200. The first mounting portion 210 and the first swing arm 200 may be of an integral structure, or may be separately manufactured, and then be assembled by means of soldering, snap-fit, or the like. A protruding second mounting portion 320 is disposed on a side, facing the first swing arm 200, of the second swing arm 300. Similarly, the second mounting portion 320 and the second swing arm 300 may be of an integral structure, or may be separately manufactured, and then be assembled by means of soldering, snap-fit, or the like.

The first end of the synchronizing link 400 is rotationally connected to the first mounting portion 210, the second end of the synchronizing link 400 is rotationally connected to the second mounting portion 320. A specific rotational connection manner may be implemented by using a structure such as the rotary shaft 120 or an elastic connector. For example, the rotary shaft 120 may be disposed at the first end of the synchronizing link 400, a shaft hole may be disposed in the first mounting portion 210, and rotational connection between the first end of the synchronizing link 400 and the first mounting portion 210 is implemented by means of cooperation of the rotary shaft 120 and the shaft hole. Alternatively, the elastic connector may be used to be respectively connected to the first mounting portion 210 and the first end of the synchronizing link 400. The elastic connector may be a rubber member, a torsion spring, or the like. Rotational connection between the first end of the synchronizing link 400 and the first mounting portion 210 is implemented by means of deformation of the elastic connector. Rotational connection between the second mounting portion 320 and the second end of the synchronizing link 400 may be implemented with reference to the foregoing connection manner.

The first mounting portion 210 and the second mounting portion 320 are disposed, so that there is no need to dispose a connection structure based on the original structure of the first swing arm 200 and the second swing arm 300, to avoid an impact on structural strength of the first swing arm 200 and the second swing arm 300. In addition, the first mounting portion 210 and the second mounting portion 320 can further help reinforce the structure, so that stability of the hinge mechanism 10 is improved. In addition, sizes of the first mounting portion 210 and the second mounting portion 320 are smaller than those of the first swing arm 200 and the second swing arm 300, so that a weight and a size of the hinge mechanism 10 can be reduced.

Further, as shown in FIG. 1 to FIG. 4, in the extension direction of the synchronizing link 400, a projection of the first mounting portion 210 and a projection of the second mounting portion 320 may at least partially overlap, so that an extension span of the synchronizing link 400 can be reduced to some extent, thereby improving stability between the synchronizing link 400, the first mounting portion 210, and the second mounting portion 320, and reducing a probability that the synchronizing link 400 gets stuck in rotational cooperation with the first mounting portion 210 and the second mounting portion 320.

In the extension direction of the synchronizing link 400, the projection of the first mounting portion 210 and the projection of the second mounting portion 320 may partially overlap or completely overlap. For example, the projection of the first mounting portion 210 and the projection of the second mounting portion 320 completely overlap. In this case, the extension span of the synchronizing link 400 is the smallest, and the synchronizing link 400 is not prone to be deformed due to a force, to ensure synchronization between the first swing arm 200 and the second swing arm 300, thereby improving stability of the hinge mechanism 10.

In an optional implementation of this application, as shown in FIG. 1 to FIG. 7, one of the first mounting portion 210 and the first end of the synchronizing link 400 is provided with a first pin shaft 220, and the other is provided with a first shaft hole. The first pin shaft 220 passes through the first shaft hole and is in rotational cooperation with the first shaft hole. The first pin shaft 220 may be disposed on the first mounting portion 210, and the first shaft hole may be disposed at the first end of the synchronizing link 400. Alternatively, the first shaft hole may be disposed in the first mounting portion 210, and the first pin shaft 220 may be disposed at the first end of the synchronizing link 400.

One of the second mounting portion 320 and the second end of the synchronizing link 400 is provided with a second pin shaft 330, and the other is provided with a second shaft hole. The second pin shaft 330 passes through the second shaft hole and is in rotational cooperation with the second shaft hole. The second pin shaft 330 may be disposed on the second mounting portion 320, and the second shaft hole may be disposed at the second end of the synchronizing link 400. Alternatively, the second shaft hole may be disposed in the second mounting portion 320, and the second pin shaft 330 may be disposed at the second end of the synchronizing link 400.

When the synchronizing link 400 applies the force to the first swing arm 200 and the second swing arm 300, the synchronizing link 400 may adjust angles between the synchronizing link 400 and the first swing arm 200 and the second swing arm 300 by means of rotational cooperation of the shaft hole and the pin shaft, to avoid a problem that the synchronizing link 400 gets stuck.

Further, as shown in FIG. 1 to FIG. 4, the first mounting portion 210 may be provided with a first avoidance groove 230, the second mounting portion 320 may be provided with a second avoidance groove 340, and a notch of the first avoidance groove 230 is disposed opposite to a notch of the second avoidance groove 340. The first avoidance groove 230 is configured to accommodate the first end of the synchronizing link 400, and at least a part of the first end is disposed in the first avoidance groove 230, to make connection between the synchronizing link 400 and the first swing arm 200 more compact. The second avoidance groove 340 is configured to accommodate the second end of the synchronizing link 400, and at least a part of the second end is disposed in the second avoidance groove 340, to make connection between the synchronizing link 400 and the second swing arm 300 more compact.

The first avoidance groove 230 and the second avoidance groove 340 are provided, so that the size of the hinge mechanism 10 can be reduced to some extent. In addition, the avoidance grooves can further have a limiting function for the ends of the synchronizing link 400, to prevent the synchronizing link 400 from being offset and affecting an effect of synchronization between the first swing arm 200 and the second swing arm 300.

In a case that the first pin shaft 220 is disposed on the first mounting portion 210, two ends of the first pin shaft 220 are respectively connected to a groove wall of the first avoidance groove 230. Specifically, two mounting holes may be provided in the groove wall of the first avoidance groove 230. The two ends of the first pin shaft 220 respectively extend into the mounting holes to implement mounting. The first end of the synchronizing link 400 is provided with the first shaft hole, the first end extends into the first avoidance groove 230, and the first pin shaft 220 passes through the first shaft hole, to implement rotational connection between the first end of the synchronizing link 400 and the first mounting portion 210.

In a case that the second pin shaft 330 is disposed on the second mounting portion 320, two ends of the second pin shaft 330 are respectively connected to a groove wall of the second avoidance groove 340. Specifically, two mounting holes may be provided in the groove wall of the second avoidance groove 340. The two ends of the second pin shaft 330 respectively extend into the mounting holes to implement mounting. The second end of the synchronizing link 400 is provided with the second shaft hole, the second end extends into the second avoidance groove 340, and the second pin shaft 330 passes through the second shaft hole, to implement rotational connection between the second end of the synchronizing link 400 and the second mounting portion 320.

In addition, in a case that the first shaft hole is provided in the first mounting portion 210, and the first pin shaft 220 is disposed at the first end of the synchronizing link 400, the first avoidance groove 230 may be provided at the first end of the synchronizing link 400, and at least a part of the first mounting portion 210 extends into the first avoidance groove 230. Similarly, in a case that the second shaft hole is disposed in the second mounting portion 320, and the second pin shaft 330 is disposed at the second end of the synchronizing link 400, the second avoidance groove 340 may be provided at the second end of the synchronizing link 400, and at least a part of the second mounting portion 320 extends into the second avoidance groove 340.

It should be noted that the connection manner between the first mounting portion 210 and the first end of the synchronizing link 400 may be the same as or different from the connection manner between the second mounting portion 320 and the second end of the synchronizing link 400. For example, the first shaft hole may be provided in the first mounting portion 210, and the first pin shaft 220 is disposed at the first end of the synchronizing link 400. Correspondingly, the first avoidance groove 230 may be provided at the first end of the synchronizing link 400. Alternatively, the first pin shaft 220 may be disposed on the first mounting portion 210, and the first shaft hole is disposed at the first end of the synchronizing link 400. Correspondingly, the first avoidance groove 230 may be provided in the first mounting portion 210. For the second mounting portion 320 and the second end of the synchronizing link 400, reference may be made to the foregoing connection manners, and the foregoing connection manners may be combined based on an actual requirement, provided that rotational connection between the synchronizing link 400 and the first swing arm 200 and the second swing arm 300 can be implemented. This is not limited in this embodiment of this application.

In an optional implementation of this application, as shown in FIG. 1 to FIG. 8, the hinge mechanism 10 has a first rotation axis and a second rotation axis, the first swing arm 200 rotates relative to the base 100 around the first rotation axis, and the second swing arm 300 rotates relative to the base 100 around the second rotation axis. The first rotation axis and the second rotation axis may be axes of a physical structure, or may be virtual axes derived from movement of the first swing arm 200 and the second swing arm 300.

A distance between the first rotation axis and the second rotation axis is a first distance, a distance between the first end and the second end of the synchronizing link 400 is a second distance, a distance between the first rotation axis and the first end of the synchronizing link 400 is a third distance, and a distance between the second rotation axis and the second end of the synchronizing link 400 is a fourth distance. The first distance is equal to the second distance, and the third distance is equal to the fourth distance, so that an equivalent parallelogram mechanism is formed by the first swing arm 200, the second swing arm 300, the base 100, and the synchronizing link 400. The first swing arm 200 and the second swing arm 300 can better synchronously move relative to the base 100 under an action of the parallelogram mechanism, to better avoid the problem that the first swing arm 200 and the second swing arm 300 are prone to be stuck in rotational or slidable cooperation with the base 100 or the frame connector 500, and improve stability of the hinge mechanism 10.

Further, as shown in FIG. 1 to FIG. 8, the first rotation axis is parallel to the second rotation axis, and the extension direction of the synchronizing link 400 is perpendicular to the first rotation axis or the second rotation axis. Compared with another angle, a perpendicular setting can reduce the span of the synchronizing link 400, and can further alleviate a sticking problem between the synchronizing link 400 and the first swing arm 200 and the second swing arm 300.

In an optional implementation of this application, as shown in FIG. 1 to FIG. 8, the hinge mechanism 10 may further include the frame connector 500 and the rotary shaft 120. The frame connector 500 is configured to connect a frame of the electronic device. The rotary shaft 120 is disposed on the base 100, and is connected to the base 100. An end of the first swing arm 200 is sleeved on the outside of the rotary shaft 120, and is rotationally connected to the base 100 through the rotary shaft 120. In addition, to avoid interference between the first swing arm 200 and the frame connector 500, the first swing arm 200 is further slidably connected to the frame connector 500, and the first swing arm 200 further slides relative to the frame connector 500 when the first swing arm 200 rotates relative to the base 100. The sliding groove may be disposed on the frame connector 500, to accommodate the first swing arm 200.

One end of the second swing arm 300 is provided with a bearing shell 310, the base 100 is provided with a sliding groove, and the bearing shell 310 may be slidably disposed in the sliding groove, so that the second swing arm 300 rotates relative to the base 100. The second swing arm 300 is connected to the frame of the electronic device through the frame connector 500, to drive the frame of the electronic device to switch between a folded state and an unfolded state. The other end of the second swing arm 300 is provided with a movable connection portion, and the second swing arm 300 is in movable cooperation with the frame connector 500 through the movable connection portion. A movable cooperation manner may include sliding, rotation, and the like, and may be specifically implemented in a manner like cooperation of the rotary shaft 120, the sliding groove, and a sliding part. In a process in which the frame connector 500 drives the second swing arm 300 to rotate relative to the base 100, the second swing arm 300 may move relative to the frame connector 500 by using the movable connection portion.

In a process of folding the electronic device, one part of folded angle is provided by cooperation of the sliding groove and the bearing shell 310, and the other part of folded angle is provided by movement of the second swing arm 300 relative to the frame connector 500. It may be understood that because of movable cooperation of the second swing arm 300 and the frame connector 500, normal folding of the electronic device can also be implemented without excessive relative sliding between the sliding groove and the bearing shell 310, to ensure an overlapping amount between the sliding groove and the bearing shell 310, thereby preventing the bearing shell 310 from falling out of the sliding groove, and improving stability of the hinge mechanism 10. Based on this, the size of the hinge mechanism 10 can be further reduced, which facilitates thinning of the electronic device.

In addition, the synchronizing link 400 is disposed between the first swing arm 200 and the second swing arm 300, so that the first swing arm 200 and the second swing arm 300 rotate synchronously relative to the base 100 under the action of the synchronizing link 400, so that a problem that sticking easily occurs during cooperation of the sliding groove and the bearing shell 310 and movable cooperation of the second swing arm 300 and the frame connector 500 can be avoided, thereby improving stability of the hinge mechanism 10.

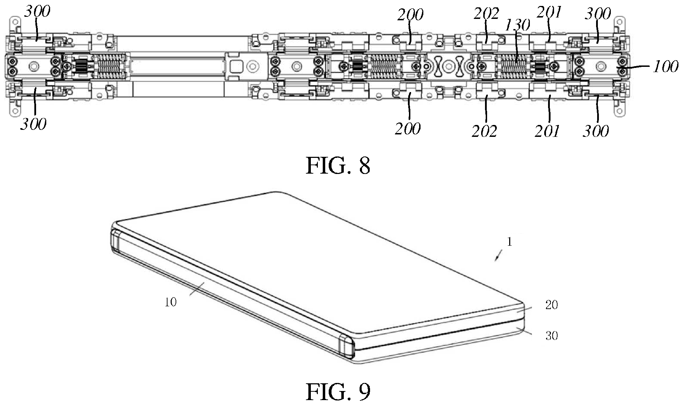

Further, as shown in FIG. 1 to FIG. 8, the base 100 includes a first side and a second side that are opposite to each other. To improve stability of the hinge mechanism 10, at least two first swing arms 200 and at least two second swing arms 300 are disposed on both the first side and the second side of the base 100. Both the first swing arm 200 and the second swing arm 300 are arranged in a length direction of the base 100. For example, as shown in FIG. 8, in the length direction of the base 100, three first swing arms 200 and two second swing arms 300 are disposed on both the first side and the second side of the base 100. A synchronization mechanism 600 is disposed between the first swing arm 200 disposed on the first side and the first swing arm 200 disposed on the second side. The synchronization mechanism 600 may include components such as a synchronization gear and the rotary shaft 120. The first swing arms 200 on the two sides of the base 100 can synchronously rotate relative to the base 100 under an action of the synchronization mechanism. In cooperation with the frame connector 500, the frame of the electronic device on the two sides of the base 100 can synchronously rotate.

The at least two first swing arms 200 and the at least two second swing arms 300 are disposed in the length direction of the base 100, so that a support area between the first swing arm 200, the second swing arm 300, and the frame connector 500 can be increased, thereby improving stability of the hinge mechanism 10. Based on this, the size of the hinge mechanism 10 can be further reduced, which facilitates thinning of the electronic device. It should be noted that the length direction of the base 100 is parallel to a rotation axis direction of the first swing arm 200 or the second swing arm 300.

The synchronizing links 400 are disposed between adjacent first swing arms 200 and second swing arms 300 disposed on the same side of the base 100. For example, the first swing arms 200 and the second swing arms 300 disposed on the same side of the base 100 may be disposed in a staggered manner (that is, among the swing arms disposed on the same side of the base 100, two adjacent swing arms are respectively the first swing arm 200 and the second swing arm 300). Alternatively, the second swing arms 300 may be disposed close to the ends of the base 100, and a plurality of first swing arms 200 are disposed between the two second swing arms 300. The synchronizing link 400 is disposed between the adjacent first swing arm 200 and second swing arm 300, so that stability can be further improved when the first swing arm 200 and the second swing arm 300 rotates relative to the base 100, thereby avoiding the problem that the first swing arm 200 and the second swing arm 300 are prone to be stuck in rotational or slidable cooperation with the base 100 or the frame connector 500, and improving stability of the hinge mechanism 10.

In addition, as shown in FIG. 1, FIG. 2, and FIG. 8, to enable the hinge mechanism 10 to have a damping and hovering effect, the hinge mechanism 10 may further include an elastic member 130, a first movement member 140, and a second movement member 150 that are disposed on the same side of the base 100. The first swing arm 200 may include a first sub-swing arm 201 and a second sub-swing arm 202. The first sub-swing arm 201 and the second sub-swing arm 202 are located on the same side of the base 100. The first sub-swing arm 201, the first movement member 140, the elastic member 130, the second movement member 150, and the second sub-swing arm 202 are sequentially sleeved on the rotary shaft 120, and the first sub-swing arm 201, the second sub-swing arm 202, the first movement member 140, and the second movement member 150 may slide in an axial direction of the rotary shaft 120. A first cam portion 203 is disposed on a side of the first sub-swing arm 201 close to the first movement member 140, a second cam portion 204 is disposed on a side of the second sub-swing arm 202 close to the second movement member 150. The first cam portion 203 and the second cam portion 204 each are provided with a first cam surface, and the first movement member 140 and the second movement member 150 each are provided with a second cam surface. In a process in which the first sub-swing arm 201 and the second sub-swing arm 202 rotate relative to the base 100, the first cam portion 203 and the second cam portion 204 rotate, and respectively drive the first movement member 140 and the second movement member 150 to move towards each other by using the first cam surface and the second cam surface, to squeeze the elastic member 130, thereby increasing a friction force between the elastic member 130 and the first movement member 140 and the second movement member 150, which provides a damping force for the rotation process of the first swing arm 200, and the damping force is a basis for hovering of the hinge mechanism 10. In addition, a shape of the first cam surface and the second cam surface may be correspondingly designed based on a hovering angle.

To further improve the damping effect, a third cam portion 205 is further disposed on a side, facing away from the second movement member 150, of the second sub-swing arm 202. The base 100 is provided with an engagement portion 160. The third cam portion 205 is provided with the first cam surface, and the engagement portion 160 is provided with the second cam surface. In a process in which the second sub-swing arm 202 rotates relative to the base 100, the third cam portion 205 rotates relative to the engagement portion 160, and drives the second sub-swing arm 202 to move towards the second movement member 150 by using the first cam surface and the second cam surface, to push against the second movement member 150, so that the second movement member 150 may slide in the axial direction of the rotary shaft 120 under an action of the two cam portions, and a stroke of the second movement member 150 is increased. In this way, the elastic member 130 can be further squeezed, to further improve the damping effect.

As shown in FIG. 9, this embodiment of this application further discloses an electronic device 1. The disclosed electronic device 1 may be a smartphone, a tablet computer, an e-book reader, a game console, a wearable device, or the like that has a foldable function. A specific type of the electronic device is not limited in this embodiment of this application.

The electronic device 1 may include a first device body 20, a second device body 30, and the hinge mechanism 10 according to the foregoing embodiments. The first device body 20 is connected to the second device body 30 through the hinge mechanism 10. In a relative rotation process of the first device body 20 and the second device body 30, the electronic device 1 switches between an unfolded state and a folded state.

Optionally, a first swing arm 200, a second swing arm 300, and a frame connector 500 are disposed on both sides of a base 100. The first device body 20 and the second device body 30 are respectively connected to the frame connector 500 located on two sides of the base 100. A synchronizing link 400 is disposed between the first swing arm 200 and the second swing arm 300, so that the first swing arm 200 and the second swing arm 300 rotate synchronously relative to the base 100 under an action of the synchronizing link 400, thereby avoiding a problem that the first swing arm 200 and the second swing arm 300 are prone to be stuck in rotational or slidable cooperation with the base 100 or the frame connector 500, and improving stability of the hinge mechanism 10, which further improve folding reliability of the electronic device. Both the first device body 20 and the second device body 30 include the foregoing housing. The frame connector 500 located on the two sides of the base 100 are respectively connected to the housing on a same side, to be connected to the first device body 20 or the second device body 30 on the same side.

The foregoing embodiments of this application focus on differences between various embodiments. As long as different technical features of the embodiments are not contradictory, the embodiments can be combined to form a more specific embodiment. Considering simplicity of the specification, this is not described in detail herein.

Embodiments of this application are described above with reference to the accompanying drawings. However, this application is not limited to the foregoing specific implementations. The foregoing specific implementations are merely examples, but are not limitative. Under the enlightenment of this application, a person of ordinary skill in the art may further make many forms without departing from the purpose of this application and the protection scope of the claims, and all the forms fall within the protection of this application.

## Claims

1. A hinge mechanism, comprising a base, a first swing arm, a second swing arm, and a synchronizing link, wherein both the first swing arm and the second swing arm are rotationally connected to the base; and
the synchronizing link comprises a first end and a second end that are opposite to each other, and the first end and the second end are respectively rotationally connected to the first swing arm and the second swing arm that are located on a same side of the base, so that the first swing arm and the second swing arm rotate synchronously relative to the base, wherein an extension direction of the synchronizing link intersects or is non-coplanar to a rotation axis of the first swing arm or a rotation axis of the second swing arm.

2. The hinge mechanism according to claim 1, wherein a protruding first mounting portion is disposed on a side, facing the second swing arm, of the first swing arm, a protruding second mounting portion is disposed on a side, facing the first swing arm, of the second swing arm, the first end is rotationally connected to the first mounting portion, and the second end is rotationally connected to the second mounting portion.

3. The hinge mechanism according to claim 2, wherein in the extension direction of the synchronizing link, a projection of the first mounting portion and a projection of the second mounting portion at least partially overlap.

4. The hinge mechanism according to claim 2, wherein one of the first mounting portion and the first end is provided with a first pin shaft, and the other is provided with a first shaft hole, wherein the first pin shaft passes through the first shaft hole and is in rotational cooperation with the first shaft hole; and
one of the second mounting portion and the second end is provided with a second pin shaft, and the other is provided with a second shaft hole, wherein the second pin shaft passes through the second shaft hole and is in rotational cooperation with the second shaft hole.

5. The hinge mechanism according to claim 4, wherein the first mounting portion is provided with a first avoidance groove, the second mounting portion is provided with a second avoidance groove, and a notch of the first avoidance groove is disposed opposite to a notch of the second avoidance groove;
at least a part of the first end is disposed in the first avoidance groove, the first pin shaft passes through the first shaft hole, and two ends of the first pin shaft are respectively connected to a groove wall of the first avoidance groove; and
at least a part of the second end is disposed in the second avoidance groove, the second pin shaft passes through the second shaft hole, and two ends of the second pin shaft are respectively connected to a groove wall of the second avoidance groove.

6. The hinge mechanism according to claim 1, wherein the hinge mechanism has a first rotation axis and a second rotation axis, the first swing arm rotates relative to the base around the first rotation axis, and the second swing arm rotates relative to the base around the second rotation axis; and
a distance between the first rotation axis and the second rotation axis is a first distance, a distance between the first end and the second end is a second distance, a distance between the first rotation axis and the first end of the synchronizing link is a third distance, and a distance between the second rotation axis and the second end of the synchronizing link is a fourth distance, wherein the first distance is equal to the second distance, and the third distance is equal to the fourth distance.

7. The hinge mechanism according to claim 6, wherein the first rotation axis is parallel to the second rotation axis, and the extension direction of the synchronizing link is perpendicular to the first rotation axis or the second rotation axis.

8. The hinge mechanism according to claim 1, wherein the hinge mechanism further comprises a frame connector and a rotary shaft, wherein
the rotary shaft is disposed on the base, an end of the first swing arm is rotationally connected to the base through the rotary shaft, and the first swing arm is slidably connected to the frame connector; and
one end of the second swing arm is provided with a bearing shell, the base is provided with a sliding groove, the bearing shell is slidably disposed in the sliding groove, so that the second swing arm rotates relative to the base, the other end of the second swing arm is provided with a movable connection portion, and the second swing arm is in movable cooperation with the frame connector through the movable connection portion.

9. The hinge mechanism according to claim 8, wherein the base comprises a first side and a second side that are opposite to each other, and at least two first swing arms and at least two second swing arms are disposed on both the first side and the second side;
a synchronization mechanism is disposed between the first swing arm disposed on the first side and the first swing arm disposed on the second side, and the synchronization mechanism is used to enable the first swing arms on two sides of the base to rotate synchronously; and
the synchronizing links are disposed between adjacent first swing arms and second swing arms disposed on the same side of the base.

10. An electronic device, comprising a first device body, a second device body, and the hinge mechanism according to any one of claims 1 to 9, wherein the first device body is connected to the second device body through the hinge mechanism; and
in a relative rotation process of the first device body and the second device body, the electronic device switches between an unfolded state and a folded state.
